Europäisches Patentamt

European Patent Office

Office européen des brevets

(19)

(11) Veröffentlichungsnummer: **0 089 617**
**B1**

(12) **EUROPÄISCHE PATENTSCHRIFT**

(45) Veröffentlichungstag der Patentschrift:
08.06.88

(21) Anmeldenummer: 83102608.3

(22) Anmeldetag: 16.03.83

(51) Int. Cl.⁴: **H 03 H 9/145,** H 03 H 9/44,
H 03 H 9/64

(54) Mit akustischen Wellen arbeitendes elektronisches Bauelement.

(30) Priorität: 18.03.82 DE 3209962

(43) Veröffentlichungstag der Anmeldung:
28.09.83 Patentblatt 83/39

(45) Bekanntmachung des Hinweises auf die Patenterteilung:
08.06.88 Patentblatt 88/23

(84) Benannte Vertragsstaaten:
DE FR GB

(56) Entgegenhaltungen:
EP-A-0 066 281
GB-A-2 030 411
US-A-4 184 131

1982 ULTRASONICS SYMPOSIUM PROCEEDINGS,
27.-29. Oktober 1982, San Diego, CA., Band 1, Seiten
83-87, IEEE, New York, US; G. RIHA u.a.: "RAC-
Filters with position weighted metallic strip arrays"

(73) Patentinhaber: Siemens Aktiengesellschaft Berlin
und München, Wittelsbacherplatz 2, D-8000
München 2 (DE)

(72) Erfinder: Riha, Gerd, Dipl.- Ing. Dr.,
Kamerunerstrasse 20, D-8000 München 82 (DE)

## Beschreibung

Die vorliegende Erfindung bezieht sich auf ein elektronisches Bauelement, wie es im Oberbegriff des Patentanspruchs 1 angegeben ist.

Aus dem Stand der Technik sind vielfältige Ausführungsformen von elektronischen Bauelementen bekannt, die mit akustischen Wellen arbeiten und als elektrische Frequenzfilter, Signalgeneratoren, Oszillatoren und dergl. Verwendung finden. In der Regel haben sie wenigstens einen Eingangswandler und wenigstens einen Ausgangswandler, die je nach Ausführungsform gegebenenfalls auch funktionell in einen Wandler zusammenfallen können. Solche Wandler können den Aufbau einer Interdigitalstruktur mit ineinandergreifenden Elektrodenfingern haben.

Von Bedeutung sind solche Ausführungsformen derartiger elektronischer Bauelemente, die zusätzlich zu Eingangswandler und Ausgangswandler eine oder mehrere Reflektorstrukturen haben, die ebenfalls aus jeweils einer Vielzahl von Fingern bzw. Digitstreifen bzw. diesen entsprechenden Konfigurationen bestehen. Es gibt 'in-line'-Reflektorstrukturen (normal incidence), bei denen in der Reflektorstruktur 180° Reflexion an den Fingern erfolgt andere derartige Reflektoranordnungen haben zwei oder mehr nebeneinander angeordnete Reflektorstrukturen, wobei die Finger jeweils einer Reflektorstruktur in einem Winkel von etwa 90° zu den Fingern einer anderen Reflektorstruktur angeordnet sind (oblique incidence).

Ein elektronisches Bauelement der oben beschriebenen Arten kann so bemessen werden, daß es eine einer vorgegebenen Übertragungsfunktion entsprechende Signalverarbeitung ausführt und das dieser Funktion entsprechende Ausgangssignal abgibt. Bemessen werden dazu der Fingerabstand und die Wichtung der einzelnen Finger, wobei für Filter mit dispersiver Eigenschaft sich ändernder Fingerabstand vorgesehen wird. Bekanntermaßen erfolgt das mathematische Ermitteln der notwendigen Bemessungen durch Bildung der Fouriertransformierten der Übertragungsfunktion. Diese Fouriertransformierte wird auch als Filter-Impulsantwort bezeichnet. Sie kann als komplex Funktion

$$s(t) = a(t) \, e^{j[\omega_0 t + \varphi(t)]}$$

dargestellt werden. Diese Funktion verlangt für $a(t) \neq$ konst im Bauelement wenigstens eine gewichtete Digitalstruktur. Die Wichtung einer Digitstruktur bzw. der einzelnen Finger dieser Struktur ist eine gezielte Verminderung der mechanischen bzw. elektromechanischen Wirksamkeit dieser Finger in der Struktur. Für eine Interdigitalstruktur ist es dazu bekannt, die einander benachbarten, auf voneinander verschiedenem Potential befindlichen Elektrodenfinger einander verschieden weit überlappen zu lassen. Bei starker Wichtung ergibt sich örtlich nur noch sehr geringe Überlappung, die zu nachteiligen Wellenbeugungen führt.

Für Reflektorstrukturen gibt es außer der meistenteils sehr nachteiligen Maßnahme einer mehr oder weniger starken Verkürzung eines jeweiligen Fingers diejenige, anstelle eines als durchgehenden Streifen ausgebildeten (ungewichteten) Fingers eine dem Streifen entsprechende Reihe einzelner Punkte - als 'dots' bezeichnet vorzusehen. Diese mehr oder weniger groß bemessene Dichte und/oder Größe der 'dots' entspricht einem mehr oder weniger verkürzten und damit gewichteten Finger (und eine solche jeweilige, einen Finger ersetzende Struktur wird hier auch als Finger oder Digitstreifen bezeichnet). Nachteilig für eine solche Ausführung ist, daß die 'dots' Störsignale aufgrund unerwünschten Reflexions- und Streuverhaltens (insbesondere bei stärkerer Wichtung, d.h. geringer Dichte der 'dots') hervorrufen. Die ursprüngliche Ausführungsform gewichteter Finger bei einer Reflektorstruktur besteht darin, diese als Gruben bzw. Gräben in der Oberfläche des Substrats zu realisieren und einen solchen Graben der Wichtung entsprechend mehr oder weniger tief zu machen. Diese Technologie hat wiederum den Nachteil, daß sie außerordentlich kostspielig und schwer kontrollierbar ist.

Zum Stand der Technik sei verwiesen auf: 1979-Ultrasonic Symposium Proceedings IEEE, Seiten 696 bis 700 (Chapman) und Seiten 585 bis 589 (Kitano) ; 1976-Ultrasonic Symposium Proceedings IEEE, Seiten 406-410 (Godfrey).

Aus der US-A-4 184 131 ist ein mit Oberflächenwellen arbeitendes Filter bekannt, mit dem ein Filter zu ersetzen ist, das aus konzentrierten Bauelementen besteht. Dieses Oberflächenwellenfilter hat eine Fingerstruktur mit gruppenweiser Anordnung dieser Finger, die Abstände in der Größe der halben Wellenlänge der Mittenfrequenz des Filters haben. Dort wo verschiedene Gruppen der Finger aneinanderstoßen, liegen Fingerabstände in der Größe eines Viertels bzw. von drei Viertel der Wellenlänge vor.

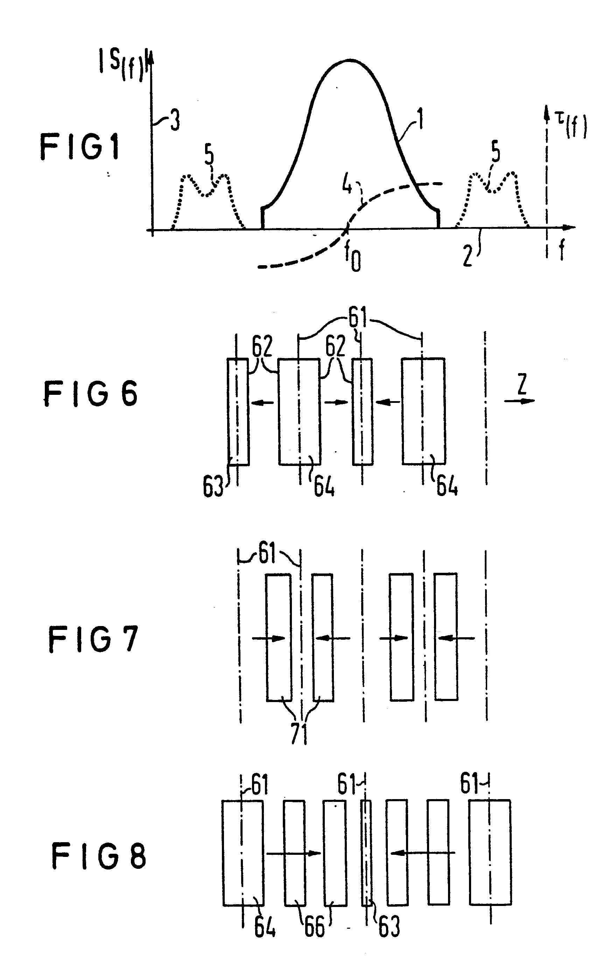

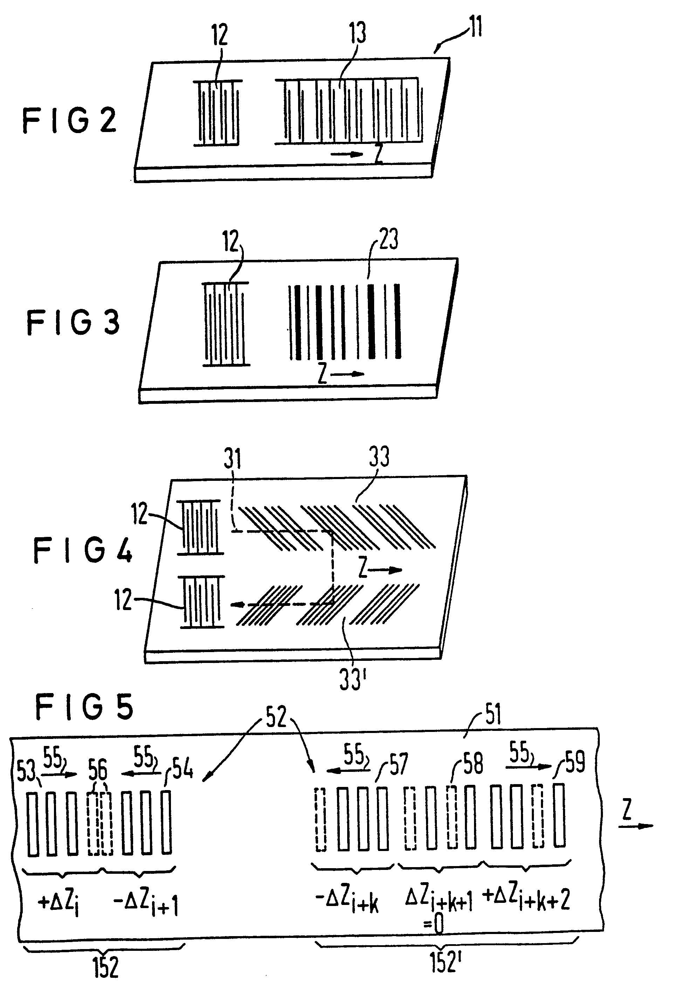

Aus der GB-A-2 030 411 ist ein Oberflächenwellenfilter bekannt, das der vorgesehenen Dispersion des Filters entsprechend sich fortlaufend ändernde Breite der Finger und sich fortlaufend ändernde Abstände der Finger aufweist. Es ist dort solche Verteilungswichtung vorgesehen, durch die einzelne Gruppen zueinander in Phase oder in Gegenphase sind. Dies ergibt insgesamt eine Wichtung der Struktur. Die Figur 2c zeigt differentielle Fingerverschiebung eines Fingers, die ebenfalls eine Fingerverschiebung-Wichtung darstellt.

Es ist eine Aufgabe der vorliegenden Erfindung, eine solche technologische Ausführung der Wichtung der Finger einer insbesondere für eine Reflektorstruktur verwendeten Digitstruktur anzugeben, die (etwa vergleichsweise zu Wichtung durch unterschiedlich tiefe Gräben) weniger aufwendig und leichter kontrollierbar ist und/oder höchstens zu minimalen Störungen (etwa vergleichsweise zu einer Wichtung mit 'dots') führt, bzw. für eine Elektrodenfingerstruktur anzugeben, die auch bei großen Wichtungen keinen darauf beruhenden Beugungseffekt hat.

Diese Aufgabe wird für ein elektronisches Bauelement nach dem Oberbegriff des Patentanspruchs 1 mit den Merkmalen des Kennzeichens dieses Patentanspruchs gelöst.

Der Erfindung liegen folgende Überlegungen und Erkenntnisse zugrunde.

Fig. 1 zeigt über der auf der Abszisse 2 aufgetragenen Frequenz den vorgegebenen Amplitudenverlauf 1 einer Übertragungsfunktion (die Amplitude ist auf der Ordinate aufgetragen). Die Fig. 1 zeigt zusätzlich mit gestrichelter Kurve 4 (zu der auf der Ordinate die Gruppenlaufzeit aufgetragen ist) den dem vorgegebenen Amplitudenverlauf 1 zugehörigen vorgegebenen Verlauf der Gruppenlaufzeit $\tau(f)$ der gesamten geforderten Übertragungsfunktion des mit akustischen Wellen arbeitenden Bauelements nach der Erfindung. Die dargestellte Übertragungsfunktion ist ein Beispiel, wie es typischerweise für Pulskompressionsfilter auftritt. Dieser aus den beiden Kurven 1 und 4 bestehenden Übertragungsfunktion entspricht eine bestimmte Fouriertransformierte, die die von der Zeit abhängige Filter-Impulsantwort ist:

$$s(t) = a(t) \cdot e^{j[\omega t + \varphi(t)]}. \tag{I}$$

Für die Bemessung der Finger nach der Erfindung wird dieser Ausdruck in die folgende Form umgewandelt, in der sich die Funktion s(t) aus der Faltung mit der Funktion š(t) ergibt:

$$s(t) = \{r(t) \cdot e^{j[wot + \varphi(t) + b(t)]}\} {}^* g(t) = š(t) {}^* g(t). \tag{II}$$

In dieser Darstellung ist die Amplitudenfunktion a(t) in die Phasenfunktion b(t) übergeführt worden, die entsprechend entscheidend für die erfindungsgemäße Bemessung der Verschiebung von Fingerkanten zum Zwecke der Wichtung der betreffenden Struktur ist. Diese bei der Erfindung zu realisierende Wichtung a(t) ergibt sich aus der für das betreffende Bauelement vorgegebenen Übertragungsfunktion nach Betrag 1 und Gruppenlaufzeit 4 desselben.

Mit dieser mathematischen Transformation von s(t) in š(t) geht das Auftreten des Ausdrucks r(t) und der Faltungsfunktion g(t) einher. Die Funktion r(t) ist die Einhüllende der nicht mit der erfindungsgemäßen zusätzlichen Phasenwichtung ausgestatteten Digitalstruktur. Der Vollständigkeit halber sei darauf hingewiesen, daß diese Funktion r(t) auch eine zusätzliche Amplitudenmodulation enthalten kann, die bei einem erfindungsgemäßen Bauelement nach einer der bekannten, z. B. oben beschriebenen, Methoden der Fingerwichtung zu realisieren wäre. Die Faltungsfunktion g(t) stellt im wesentlichen die Filter-Impulsantwort von Eingangs- und/oder Ausgangswandler bei einer Interdigitalstruktur bzw. einer 'in-line'-Reflektorstruktur dar, oder sie entspricht der der Apertur einer Reflektorstruktur mit schräggestellten Reflektorfingern, d. h. mit zweimaliger 90° Reflexion, eigenen faltungsähnlichen Integration (Filterung). Diese Funktion g(t) wird mit der erfindungsgemäß modifizierten Funktion š(t) Gleichung (II) gefaltet. Dieser mathematisch als Faltung bezeichnete Vorgang entspricht im Frequenzbereich (der Darstellung der Fig. 1) einer Ausfilterung von Seitenbändern. In der Fig. 1 sind solche im Zusammenhang mit der Erfindung auftretende Seitenbänder mit punktiertem Kurvenzug dargestellt und mit 5 bezeichnet.

Die erwähnten Seitenbänder 5 werden im Zusammenhang mit der Erfindung weggefiltert, und zwar in erster Linie durch entsprechende Bemessung des Eingangswandlers und/oder des Ausgangswandlers. Wie ebenfalls schon mit anderen Worten gesagt, kann dies für die Reflektorstruktur mit schräggestellten Fingern durch Wahl eines entsprechend großen Aperturwertes, d.h. entsprechend langen Fingern der Struktur, erzielt werden. Lediglich der Vollständigkeit halber sei darauf hingewiesen, daß diese Filterung aber auch außerhalb des eigentlichen erfindungsgemäßen Bauelements erfolgen kann, z. B. in weiteren filtern wirkenden Baugruppen eines ganzen Gerätes. Wegen der sich bei einem erfindungsgemäßen Bauelement bietenden sehr einfachen Möglichkeit der Ausfilterung solcher Seitenbänder 5, wird aber von der letztgenannten Möglichkeit selten Gebrauch gemacht.

Zur Realisierung der modifizierten Funktion š(t) (entsprechend Gleichung II) sind in einer erfindungsgemäßen Digitalstruktur Fingerkanten oszillierend (mit einer Mindestfrequenz) verschoben, und zwar gegenüber einer örtlichen Lage (in der Struutur), die sich für eine entsprechende Digitalstruktur ergeben würde, wenn diese am betreffenden Ort der jeweiligen Fingerkante keine Wichtung hätte, d.h. die Finger dort ungewichtet wären. Zum Beispiel sind in einer ungewichteten, nicht dispersiven Digitalstruktur die Finger und damit auch ihre Fingerkanten in äquidistanten Abständen angeordnet, so bei Interdigital-Anordnungen (ohne 'split fingers') und in 'in-line'-Reflektorstrukturen in $\lambda_o/2$ Abständen und bei einer Reflektorstruktur mit schräggestellten Fingern und zweimaliger 90°-Reflexion in Abständen $\lambda_o$, und zwar parallel zur Hauptachse bzw. Normalen der Wellenfront der akustischen Welle gemessen.

Die erfindungsgemäß vorgesehene Verschiebung der Fingerkanten erfolgt entsprechend der (noch weiter zu erörternden) Funktion b(t), und zwar gruppenweise für die Fingerkanten. Es wird eine jeweilige Anzahl von Fingerkanten zu einzelnen Subgruppen zusammengefaßt, d.h. für alle Fingerkanten einer jeweiligen Subgruppe gilt jeweils dasselbe Maß der Verschiebung nach Betrag und Richtung. In einem gewichteten Bereich einer erfindungsgemäßen Digitalstruktur ist eine Vielzahl von Subgruppen vorhanden. Eine jede Subgruppe hat mindestens zwei reale Fingerkanten, kann aber auch eine größere Anzahl Fingerkanten umfassen. Diese weiteren Fingerkanten können reale und virtuelle Fingerkanten sein. Eine reale Fingerkante ist eine solche Kante eines Fingers bzw. Digitstreifens, der tatsächlich in der Struktur z. B. als Metallisierungsstreifen vorhanden ist. Eine virtuelle Fingerkante ist im Sinne der Erfindung eine Fingerkante eines Fingers oder Digitstreifens, der in der Struktur weggelassen ist. Für eine Digitalstruktur ist es nämlich nicht notwendig, daß sie dem Maß der Wellenlänge der Mittenfrequenz entsprechend mit der maximal möglichen Anzahl Finger bzw. Digitstreifen versehen ist. Bekanntermaßen hat eine Digitalstruktur auch die entsprechende Wirkung, wenn eine mehr oder weniger große Anzahl von Fingern weggelassen ist (verdünnte Digitalstruktur).

Die voranstehend erörterte Definition einer Subgruppe enthält u.a. die Möglichkeit, daß sie aus zwei realen Fingerkanten besteht, wobei diese zwei realen Fingerkanten zu ein und demselben Finger(n) gehören. Eine weitere Möglichkeit ist, daß sie wiederum aus zwei realen Fingerkanten besteht, wobei jedoch diese beiden Fingerkanten die einander benachbarten Fingerkanten zweier benachbarter Finger sind. Die Grenze zwischen zwei benachbarten Subgruppen läuft dementsprechend durch einen Finger hindurch. Eine Subgruppe kann beispielsweise auch aus drei realen Fingerkanten bestehen, die dann damit einen kompletten Finger und die Hälfte eines benachbarten Fingers umfaßt, dessen andere Hälfte bereits der nächsten Subgruppe angehört. Ist z. B. in einer betreffenden Digitalstruktur jeder zweite Finger weggelassen, so besteht eine Kleinste Subgruppe aus vier Fingerkanten, nämlich zwei realen und zwei virtuellen Fingerkanten, d.h. aus einem vollständigen Finger oder aus zwei Hälften je eines Fingers mit einem dazwischen ausgelassenen Finger.

Bei der Erfindung wird eine Anzahl Subgruppen zur erfindungsgemäßen Bemessung der Fingerkanten-Verschiebung zu je einer Hauptgruppe zusammengefaßt. Eine jede Hauptgruppe enthält mindestens zwei reale, d.h. tatsächlich in der Struktur durch Finger repräsentierte Subgruppen. Für diese beiden Subgruppen einer jeweiligen Hauptgruppe gilt die Vorschrift, daß die Fingerkanten der einen Subgruppe entgegengesetzt (aufeinander zu oder voneinander weg) zu den Fingerkanten der anderen Subgruppe verschoben werden. Für eine Hauptgruppe mit mehr als zwei Subgruppen liegen mehrere Möglichkeiten vor, so z. B. bei drei Subgruppen, daß die mittlere Subgruppe unverschoben bleibt und nur die Fingerkanten der einen äußeren Subgruppe zu denen der anderen verschoben werden. In einem Hauptgruppe aus vier Subgruppen können z. B. eine oder zweiSubgruppen unverschoben bleiben. Die Beträge der Verschiebungen der realen Subgruppen einer Hauptgruppe (mit mehr als zwei realen Subgruppen) müssen nicht gleich sein. Es muß jedoch die Summe der Verschiebungen aller Subgruppen einer solchen Hauptgruppe gleich Null sein, abgesehen davon, daß bei unterschiedlichen Fingerabständen aufgrund einer vorgegebenen Dispersion bzw. nicht-konstanten Gruppenlaufzeit das Maß dieser Finger-Abstandsunterschiede (als sehr geringe Korrekturgröße) eingeht und/oder abgesehen davon, daß Finger einer jeweiligen Subgruppe unterschiedlichen elektromechanischen (Interdigitalwandler) mechanischen (Reflektor) Wirkungsgrad haben und/oder daß ihre Anzahl verschieden ist.

Zur Realisierung der Erfindung gilt auch eine Vorschrift für die Mindestanzahl n der Hauptgruppen, und zwar es gilt, n muß wenigstens gleich oder größer als das Zeit-Bandbreite-Produkt (T.B) sein, worin T die Dauer der Filter-Impulsantwort und B die Bandbreite der vorgegebenen Übertragungsfunktion (siehe Fig. 1) ist.

Bereits oben wurde erwähnt, daß noch weitere Angaben zur Funktion der zusätzlichen Phasenmodulation b(t) zu machen sind. Es gilt die Beziehung

$$e^{jb(t)} \approx \frac{a(t)}{r(t)}, \tag{III}$$

worin $e^{jb(t)}$ das Mittel dieser e-Funktion über eine Hauptgruppe ist.

Eine Einhüllende a(t), welche verschieden von einer Konstanten ist, verursacht eine Wichtung der Amplitude 1 der Übertragungsfunktion, und zwar für eine Realisierung der Struktur mit Fingern bzw. Digitalstreifen.

Von Vorteil ist es, wenn die zwangsläufig auftretenden Seitenbänder höchstens unwesentlich mit dem geforderten Hauptband überlappen. Dies erreicht man insbesondere durch Wahl der zusätzlichen Phasenmodulation b(t), so daß die Anzahl der in einer jeweiligen Hauptgruppe enthaltenen Oszillationen gleich der Hälfte der in dieser Hauptgruppe enthaltenen realen Subgruppen ist.

Weitere Erläuterungen der Erfindung gehen aus der anhand der Figuren gegebenen Beschreibung bevorzugter Ausführungsbeispiele der Erfindung hervor.

Es zeigen

Fig. 1 eine Kurvendarstellung der vorgegebenen Übertragungsfunktion, die mit einem erfindungsgemäßen Bauelement zu realisieren ist,

Fig. 2 eine Prinzipdarstellung eines erfindungsgemäßen Bauelements als Interdigitalstruktur,

Fig. 3 ein erfindungsgemäßes Bauelement als 'in-line'-Reflektorstruktur,

Fig. 4 ein erfindungsgemäßes Bauelement als 90°-Reflek-torstruktur,

Fig. 5 einen Abschnitt eines erfindungsgemäßen Bauteils, von dem zwei Hauptgruppen der Digitalstruktur wiedergegeben sind,

Fig. 6 eine Prinzipdarstellung für eine Fingerkanten-Verschiebung, die alternierende Fingerbreiten ergibt,

Fig. 7 eine Prinzipdarstellung für eine Fingerkanten-Verschiebung, die die Fingerbreiten unverändert läßt,

Fig. 8 eine Prinzipdarstellung für eine Fingerkanten-Verschiebung, die Kombination der Verschiebungen der Fig. 6 u. 7 ist.

In Fig. 1 ist die bereits erörterte Übertragungsfunktion nach Betrag und Gruppenlaufzeit angegeben.

Die Fig. 2 zeigt ein erfindungsgemäßes Bauteil 11 in der Ausführung als Interdigitalstruktur mit einem Eingangswandler 12 und einem Ausgangswandler 13. Der Eingangswandler 12 hat konventionellen Aufbau. Insbesondere sind die Abstände der einzelnen Finger dieses Wandlers voneinander äquidistant = $\lambda_0/2$. Der Wandler 13 dagegen ist erfindungsgemäß ausgestaltet. Die Fingerwichtung dieses Wandlers 13, die nach Konventioneller Art durch unterschiedliche Längen der einzelnen Finger ausgeführt wäre, ist hier durch wie erfindungsgemäß bemessene Verschiebung ΔZ der einzelnen Finger einer jeweiligen Subgruppe realisiert, wobei im allgemeinen alle Finger gleiche Länge haben. Mit mehr oder weniger geringfügig unterschiedlicher Fingerlänge könnte eine zusätzliche Wichtung vorgesehen sein, die jedoch mit der Erfindung nichts zu tun hat.

0 089 617

Durch entsprechend große Verschiebung $\Delta Z$ der Finger und damit der Fingerkanten für die einzelnen Subgruppen kann man auch sehr starke Wichtung realisieren, ohne daß Beugungseffekte auftreten, die nämlich bei Fingerlängen-Wichtung dann auftreten, wenn entsprechend großer Wichtung die Überlappung benachbarter Finger nur noch sehr klein ist.

Die Anschlüsse der Wandler 12 und 13, das Substrat, auf dem sich die Wandler befinden, die in Richtung $\pm Z$ schräggestellten Endkanten des Substratkörpers und weitere, die Erfindung nicht berührende Einzelheiten sind konventioneller Art und bedürfen daher keiner weiteren Erläuterung.

Das in Fig. 3 gezeigte 'in-line'-Reflektor-Bauelement hat einen Wandler 12, der sowohl als Eingangswandler als auch als Ausgangswandler dient. Er kann dem Wandler 12 der Fig. 2 in praktisch allen Einzelheiten des Aufbaues entsprechen. Auch bei der Ausführungsform nach Fig. 3 kann der Wandler 12 so breitbandig sein, daß er die gesamte geforderte Übertragungsfunktion 1 nicht beeinflußt. Mit 23 ist eine erfindungsgemäß ausgestaltete Reflektorstruktur bezeichnet, die aus einzelnen, im Regelfall gleichlangen Digitstreifen besteht. Nach konventioneller Methode würde man die Wichtung einer solchen Reflektorstruktur durch entsprechend unterschiedliche Tiefe von geätzten Gräben oder durch mehr oder weniger große Dichte von 'dots' realisieren (und zwar mit den oben beschriebenen Nachteilen). Bei der Erfindung dagegen sind die Digitstreifen dieser Struktur 23, d.h. genau genommen die Fingerkanten der Digitstreifen, um das erfindungsgemäße jeweilige Maß $\Delta Z$ verschoben. Für eine nicht-dispersive Digitalstruktur 23 ergibt sich diese Verschiebung $\Delta$ als Verschiebung gegenüber äquidistantem Finger-Mittenabstand. Hat die Digitalstruktur 23 einen Dispersion, so hat sie bereits im ungewichteten Falle nicht-äquidistante Finger-Mittenabstände, denen dann dieselbe modulierte jeweilige Verschiebung $\Delta Z$ der einzelnen Fingerkanten überlagert ist.

Während für den Wandler 13 nach Fig. 2 eine solche Ausführungsform der Erfindung dargestellt ist, bei der die Finger bzw. Digitstreifen weiterhin untereinander gleiche Breite behalten und nur erfindungsgemäß unterschiedliche Abstände voneinander haben (wobei auch einzelne Finger als virtuelle Finger ausgelassen sind), so zeigt die Darstellung der Fig. 3 Finger bzw. Digitstreifen, die unterschiedliche Breite haben. Diese unterschiedlichen Breiten ergeben sich aus Verschiebung von Fingerkanten, wobei für einzelne Finger die beiden Kanten dieses einzelnen Fingers aufeinander zu verschoben sind (schmalere Finger) und bei anderen einzelnen Fingern die beiden Kanten eines solchen voneinander weg verschoben sind (breitere Finger).

Die Fig. 4 gibt zu erkennen, was unter einer 90°-Reflektorstruktur verstanden sein soll. Auch ein solches erfindungsgemäßes Bauelement hat einen Eingangswandler 12 und einen Ausgangswandler 12, die beide übereinstimmend ausgestaltet sein können. Mit 31 ist gestrichelt ein Beispiel eines Wellenweges angedeutet. Es findet je einmal Reflexion in der Reflektorstruktur 33 und in der Reflektorstruktur 33' statt, die beide schräggerichtet angeordnete Reflektorfinger haben. Mit dem Pfeil Z ist wieder die Hauptwellenrichtung bzw. Abszisse der Verschiebung $\Delta Z$ der Finger der Strukturen 33 und 33' angedeutet. Die beiden Strukturen 33, 33' haben virtuelle Finger, d.h. es sind in Lücken entsprechend Finger weggelassen. Auch bei dieser Struktur nach Fig.4 besteht die Wichtung der Strukturen 33, 33' in der Fingerkanten-Verschiebung $\Delta Z$. Im Regelfall sind die Finger der Strukturen 33, 33' für eine jede dieser Strukturen und insbesondere auch für die Strukturen untereinander gleich lang.

Die oben erwähnte Apertur einer solchen Struktur ist die Projekten der tatsächlichen Fingerlänge auf die Normale der Abszisse z, d.h. gleich der Breite der einzelnen Strukturen 33, 33'.

Lediglich der Vollständigkeit halber sei darauf hingewiesen, daß die erfindungsgemäße jeweilige Verschiebung $\Delta Z$ parallel zur Abszisse Z, d.h. hier in einer zur Fingerrichtung schrägen Richtung gemessen ist. Die zu den nachfolgenden Figuren gegebenen Erläuterungen beziehen sich auf senkrecht zur Abszisse Z ausgerichtete Finger bzw. Fingerkanten. Diese noch folgenden Erläuterungen gelten entsprechend sinngemäß auch für schräggestellte Finger bzw. Fingerkanten, wie sie in den Strukturen 33, 33' vorkommen.

Fig. 5 zeigt auf einem nach beiden Richtungen Z hin abgebrochenen Substrat 51 - in prinzipieller Darstellung - einen Anteil einer erfindungsgemäß ausgestalteten, d. h. erfindungsgemäß gewichteten Digitalstruktur 52. Von links nach rechts, d.h. in Richtung Z, folgt eine Anzahl realer und virtueller Subgruppen aufeinander. Die von links gesehen in der Darstellung der Fig. 5 erste Subgruppe ist mit 53 bezeichnet. Die nächstfolgende Subgruppe ist mit 54 bezeichnet. Entsprechend den darüber dargestellten Pfeilen 55 sind die Fingerkanten und damit die Finger dieser beiden Subgruppen 53 und 54 aufeinander zu verschoben. Das Maß der Verschiebung ist darunter mit mathematisch-analytischem Ausdruck angegeben. Die Verschiebung $\Delta Z_i$ gilt für eine jede Fingerkante der Subgruppe 53, ist nach rechts gerichtet und ist außerdem noch eine Funktion der Ortskoordinate $Z_i$ (der Mitte) der Subgruppe 53. Entsprechendes gilt für die Subgruppe 54. Die mit ausgezogenen Linien dargestellten Digitstreifen sind reale Finger mit realen Fingerkanten. Gestrichelt und mit 56 bezeichnet sind zwei Fingerplätze, d.h. virtuelle Finger angedeutet, die in der dargestellten Struktur tatsächlich nicht vorhanden sind. Vorteilhafterweise sind diese beiden Finger deshalb weggelassen, weil - wie aus der Figur ersichtlich - ihr Abstand voneinander durch die einander entgegengerichtete Verschiebung $\Delta Z$ der beiden Subgruppen 53 und 54 stark verringert ist. Ein solcher sehr klein gewordener Abstand zwischen zwei Fingern ergibt nämlich große Probleme dann, wenn eine solche Struktur eine Interdigitalstruktur ist, bei der, wie in Fig. 2 dargestellt, einander benachbarte Finger auf voneinander verschiedenem elektrischen Potential liegen und elektrische Überschläge sehr wahrscheinlich werden. Auch für Reflektorstrukturen, deren Finger auf voneinander nicht-unterschiedlichem Potential liegen, können sich in diesem Fall Nachteile bei der Fertigung ergeben. Mit 57, 58 und 59 sind drei weitere, nach rechts folgende Subgruppen bezeichnet. Der Abstand zwischen der Subgruppe 54 und der Subgruppe 57 gibt einen Hinweis auf wenigstens eine virtuelle Subgruppe. Es fehlen dort (k-2)-reale Subgruppen, d.h. es ist dort die entsprechende Anzahl von virtuellen

5

Subgruppen anzunehmen.

Wie dargestellt, werden die Fingerkanten der Finger der Subgruppe 57 nach links, diejenigen der Subgruppe 59 nach rechts und diejenigen der Subgruppe 58 nicht verschoben.

Die Subgruppen 53 und 54 bilden zusammen eine Hauptgruppe 152. Bei dieser Hauptgruppe ist die gesamte Verschiebung $+\Delta Z_i$ und $-\Delta_{i+1}$ im wesentlichen gleich Null. Entsprechends gilt für die Hauptgruppe 152', die durch die Subgruppen 57, 58 und 59 gebildet wird.

Die einzelnen Hauptgruppen entsprechen der geforderten Mindestanzahl n von Hauptgruppen und folgen entlang der Abszisse Z aufeinander. Eine entsprechende Reihenfolge bilden die Subgruppen, die gruppenweise die einzelnen Hauptgruppen bilden.

Die Fig. 6 zeigt im Ausschnitt eine spezielle Ausführungsform der Erfindung. Mit den gestrichelten Geraden 61 sind die Grenzen benachbarter Subgruppen kenntlich gemacht. Wie ersichtlich, hat eine jede Subgruppe zwei Fingerkanten 62, die jedoch jeweils zwei verschiedenen Fingern angehören. Die Grenzen 61 verlaufen damit durch die einzelnen Finger, so daß schmale Finger 63'und breite Finger 64 alternierend aufeinanderfolgen. Die Verschiebung $\Delta Z$ der einzelnen Fingerkanten 62 entspricht dem Betrag nach ihrer Ortsveränderung in Richtung Z gegenüber derjenigen Lage der Fingerkanten einer vergleichbaren Struktur mit untereinander gleich breiten Fingern, die keine der Fingerkanten-Verschiebung entsprechende Wichtung hätte.

Fig. 7 zeigt eine Darstellung, bei der die Grenzen 61 benachbarter Subgruppen zwischen benachbarten (realen oder virtuellen) Fingern liegen. Auch beim Beispiel der Fig.7 hat eine Jede Subgruppe nur zwei Fingerkanten, die (im Gegensatz zu Fig. 6) aber jeweils ein und demselben Finger 71 gehören. Die Fingerbreite bleibt hier (dem ungewichteten Falle gegenüber) konstant. Wie ersichtlich, sind aber die benachbarten Finger abwechselnd einander angenähert und voneinander entfernt gerückt. Das jeweilige Maß der Annäherung oder Entfernung der Finger 71 voneinander - ebenso wie die Verbreiterung und Verschmälerung der Finger nach Fig.6 - hängt von dem an der jeweiligen Stelle in der Digitalstruktur geforderten Wichtung ab.

Fig. 8 deutet auf eine Ausführungsform hin, bei der die beiden dargestellten Subgruppen zwischen den Grenzen 61 je sechs Fingerkanten umfassen. Wie bei Fig. 6 geht die Grenze 61 der Subgruppen durch einzelne Finger hindurch. Die Darstellung zeigt, wie sich dabei breitere Finger 66, ganz schmale Finger 63 und unverändert breite Finger 66 ergeben. Wenn es technologische Schwierigkeiten macht, einen wie in Fig. 8 dargestellten Finger 63 zu realisieren, nämlich weil er extrem schmal geworden ist, kann dieser Finger auch ohne Nachteil weggelassen werden, d.h. ein virtueller Finger sein.

**Patentansprüche**

1. Mit akustischen Wellen arbeitendes elektronisches Bauelement als Interdigitalstruktur und/oder 'reflective array'-Anordnung mit Eingangs- und Ausgangswandler und mit gegebenenfalls wenigstens einer Reflektorstruktur, wobei wenigstens eine dieser Strukturen wenigstens einen durch Fingerkantenverschiebung parallel zur Hauptachse (Z) der Wellenausbreitung gewichteten Bereich der Finger dieser Struktur hat,

gekennzeichnet dadurch,

daß in einem solchen gewichteten Bereich - vergleichsweise zu dem Fall, daß dieser Bereich ungewichtet wäre - mindestens zwei aufeinanderfolgende reale Fingerkanten und gegebenenfalls weitere virtuelle Fingerkanten (62), die nach Betrag und Richtung dasselbe Maß der Fingerkantenverschiebung aufweisen, vorliegen und eine jeweilige Subgruppe (53, 54, 57, 59) bilden,

daß eine zueinander oszillierende Verschiebung $\Delta Z$ einer wesentlichen Anzahl solcher Subgruppen (53, 54, 57, 59) vorliegt;

daß aus jeweils wenigstens zwei realen Subgruppen (53, 54; 57, 58, 59) bestehende Hauptgruppen (152) vorliegen, daß n Hauptgruppen (152) vorhanden sind mit n gleich oder größer T.B, worin T.B das Zeit-Bandbreite-Produkt ist, worin T die vorgegebene Dauer der Filter-Impulsantwort und worin B die vorgegebene Bandbreite der Übertragungsfunktion (1) ist; daß das jeweilige Maß der Verschiebung der Fingerkanten der jeweiligen einzelnen Subgruppen für die Folge der Subgruppen dieses gewichteten Bereichs einer zusätzlichen oszillierenden Phasenmodulation b(t) entspricht und diese Phasenmodulation b(t) so oszilliert, daß innerhalb einer Hauptgruppe die Anzahl der Oszillationen eine ganze Zahl ist, die nicht größer als die Hälfte der Anzahl der in dieser Hauptgruppe enthaltenen realen Subgruppen ist, wobei

$$e^{jb(t)} \approx \frac{a(t)}{r(t)}$$

gilt, worin $e^{jb(t)}$ das Mittel dieser e-Funktion über eine Hauptgruppe (152) etwa gleich dem Verhältnis

$$\frac{a(t)}{r(t)},$$

worin a(t) die vorgegebene Amplitudenmodulation der Filter-Impulsantwort und r(t) die Funktion der Einhüllenden der nicht zusätzlich phasenmoduliert gewichteten Struktur ist, wobei gilt r(t) ist gleich oder größer a(t) für alle Werte von t;

und daß das Maß der Verschiebung $\Delta Z_i$ der Fingerkanten einer jeweiligen i-ten Subgruppe an ihrem Ort $Z_i$ ihrer

Mitte

$$Zi = \frac{\lambda_i}{2\pi} \cdot b(t_i) \text{ worin } t_i = \frac{Z_i}{v} \text{ ist,}$$

worin Z die Koordinate der Hauptrichtung der Wellenausbreitung mit der Geschwindigkeit v und $\lambda_i$ die Wellenlänge am Ort der i-ten Subgruppe ist.

2. Bauteil nach Anspruch 1,
gekennzeichnet dadurch,
daß die Faltungsfunktion g(t), die sich für die vorgegebene Gesamt-Filterimpulsantwort s(t) = š(t) * g(t) ergibt, worin die Funktion š(t) die Impulsantwort der die Subgruppen aufweisenden Struktur ist, durch entsprechende Bemessung der Bandbreite einer weiteren Interdigitalstruktur (12) (Eingangswandler; Ausgangswandler) des Bauteils realisiert ist, wobei die Bandbreite dieser Struktur durch deren Fingeranzahl gegeben ist.

3. Bauteil nach Anspruch 1,
gekennzeichnet dadurch,
daß die Faltungsfunktion g(t), die sich für die vorgegebene Gesamt-Filterimpulsantwort s(t) = š(t) * g(t) ergibt, worin die Funktion š(t) die Impulsantwort der die Subgruppen aufweisenden Struktur ist, durch Bemessung der Apertur der Reflektorstruktur (33) einer 90° Reflektorstruktur (Fig. 4) realisiert ist, wobei die Apertur im wesentlichen durch die zur Wellenausbreitung orthogonale Breite der Struktur gegeben ist.

4. Bauteil nach Anspruch 1, 2 oder 3,
gekennzeichnet dadurch,
daß die Verschiebung $\Delta Z_i$ der Fingerkanten (62) einer jeweiligen Subgruppe an wenigstens einer Reflektorstruktur (23, 33) des Bauteils vorgesehen ist.

5. Bauteil nach Anspruch 4,
gekennzeichnet dadurch,
daß die Reflektorstruktur eine 'in-line'-Reflektorstruktur (Fig.3) ist.

6. Bauteil nach Anspruch 4,
gekennzeichnet dadurch,
daß die Reflektorstruktur eine 90°-Reflektorstruktur ist.(Fig.4).

7. Bauteil nach einem der Ansprüche 1 bis 6,
gekennzeichnet dadurch, daß alle Subgruppen (71), deren Fingerkanten um $\Delta Z_i$ verschoben sind, vollständige Finger haben (Fig.7).

8. Bauteil nach einem der Ansprüche 1 bis 7,
gkennzeichnet dadurch,
daß die der Fingerwichtung entsprechende Verschiebung $\Delta Z_1$ der Fingerkanten der einzelnen Subgruppen einer Fingeranordnung überlagert ist, die einer Digitalstruktur mit Dispersion entspricht.

9. Bauteil nach einem der Ansprüche 1 bis 8,
gekennzeichnet dadurch,
daß die jeweilige Verschiebung $\Delta Z_i$ der Fingerkanten in den einzelnen Subgruppen (57, 59) gegenüber der Mittelpunktlage der zugehörigen Hauptgruppe überlagert ist den äquidistanten Abständen der Mittellage der aufeinanderfolgenden Hauptgruppen.

10. Bauteil nach einem der Ansprüche 1 bis 9,
gekennzeichnet dadurch
daß bei aufeinander zu verschobenen Subgruppen 53, 54 einer oder beide der benachbarten, dicht aneinandergerückte Finger als virtuelle Finger 56 weggelassen sind.

11. Bauteil nach einem der Ansprüche 1 bis 10,
gekennzeichnet dadurch,
daß die zusätzliche Phasenmodulation b(t) so oszilliert, daß bei Hauptgruppen mit geradzahliger Anzahl von Subgruppen die Anzahl der in einer jeweiligen Hauptgruppe enthaltenen vollständigen Oszillationen gleich der halben Anzahl der in dieser Hauptgruppe enthaltenen realen Subgruppen ist.

12. Bauteil nach einem der Ansprüche 1 bis 11,
gekennzeichnet dadurch, daß eine jede Subgruppe eine gerade Anzahl von realen Fingerkanten hat.

13. Bauteil nach einem der Ansprüche 1 bis 12,
gekennzeichnet dadurch,
daß alle Finger Konstante Länge (konstante Überlappung) aufweisen.

**Claims**

1. A surface acoustic wave electronic component, as an interdigitated structure and/or reflective array comprising input and output transducers and at least one reflector structure if need be, where at least one of these structures comprises at least one weighted region in which the fingers are weighted by finger edge formation displacement parallel to the main axis (Z) of the wave propagation, characterised in that

in a weighted region of this kind - in comparison to the situation in which said region is unweighted - at least two consecutive real finger edges and possibly further virtual finger edges (62) are provided which exhibit the same extent of finger edge displacement in respect of quantity and direction and form a respective sub-group (53, 54, 57, 59);

that a mutually oscillatory displacement $\Delta Z$ of a substantial number of such sub-groups (53, 54, 57, 59) is provided;

that main groups (152) are provided which each consist of at least two real sub-groups (53, 54; 57, 58, 59);

that n main groups (152) are provided, where:

n is equal to or greater than TB;

T.B is the time-bandwidth-product;

T is the predetermined duration of the filter pulse response; and

B is the predetermined bandwidth of the transformation function (1);

that the respective extent of the formed displacement of the finger edges of the respective individual sub-groups for the sequence of sub-groups of this weighted region corresponds to an additional oscillatory phase modulation b(t), and this phase modulation b(t) oscillates in such manner that within a main group the number of oscillation periods is a whole number which is no greater than half the number of real sub-groups contained in this main group, where

$$e^{jb(t)} \approx \tfrac{a(t)}{r(t)}, \tag{III}$$

wherein $e^{jb(t)}$ is the mean of this e-function over a main group (152) approximately equal to the ratio:

$$\frac{a(t)}{r(t)}>$$

where:

a(t) is the predetermined amplitude modulation of the filter pulse response; and

r(t) is the function of the envelope of the structure which has not been additionally weighted in phase-modulated fashion;

and where:

r(t) is equal to or greater than a(t) for all values of t; and

that the extent of the formed displacement $\Delta Z_i$ of the finger edges of a respective i-th sub-group at the location $Z_i$ of its centre is:

$$Z_i = \tfrac{\lambda_i}{2\pi} \cdot b(t_i),$$

wherein $t_i \tfrac{Z}{v}$

wherein:

Z is the coordinate of the main direction of the wave propogatons at the speed v; and

$\lambda_i$ is the wavelength at the location of the i-th sub-group.

2. A component as claimed in Claim 1, <u>characterised in that</u> the folding (convolution) function g(t) which occurs for the predetermined overall filter pulse response s(t) = s̃(t) * g(t), where the function s̃(t) is pulse response of the structure comprising the sub-groups, is achieved by appropriate dimensioning of the bandwidth of a further interdigitated structure (12) (input transducer; output transducer) of the component, where the bandwidth of this structure is governed by the number of fingers thereof.

3. A component as claimed in Claim 1, <u>characterised in that</u> the folding (convolution) function g(t) which occurs for the predetermined overall filter pulse response s(t) = s̃(t) * g(t), where the function s̃(t) is the pulse response of the structure which comprises the sub-groups, is achieved by dimensioning the aperture of the reflector structure (33) of a 90° reflector structure (Figure 4), where the aperture is fundamentally governed by the width of the structure orthogonal to the wave propagation.

4. A component as claimed in Claim 1, 2 or 3, <u>characterised in that</u> the formed displacement $\Delta Z_i$ of the finger edges (62) of a respective sub-group is provided in at least one reflector structure (23, 33) of the ccmponent.

5. A component as claimed in Claim 4, <u>characterised in that</u> the reflector structure is an in-line reflector structure (Figure 3).

6. A component as claimed in Claim 4, <u>characterised in that</u> the reflector structure is a 90° reflector structure (Figure 4).

7. A component as claimed in one of Claims 1 to 6, <u>characterised in that</u> all the sub-groups (71) whose finger edges are formed displaced by $\Delta Z_i$ have complete fingers (Figure 7).

8. A component as claimed in one of Claims 1 to 7, <u>characterized in that</u> the formed displacement $\Delta Z_i$ of the finger edges of the individual sub-groups, which correspond to the finger weighting, is superimposed upon a finger arrangement which corresponds to a digital structure designed with dispersion.

9. A component as claimed in one of Claims 1 to 8, <u>characterised in that</u> the respective formed displacement $\Delta Z_i$ of the finger edges in the individual sub-groups (57, 59) relative to the centre point position of the associated main group is superimposed upon the equidistant spacings of the central positions of the consecutive main groups.

10. A component as claimed in one of Claims 1 to 9, <u>characterised In that</u> when sub-groups (53, 54) are to be formed displaced towards one another, and where one or both of two adjacent fingers which would have been formed very close to one another are not formed, but omitted to be effective as virtual fingers (56).

11. A component as claimed in one of Claims 1 to 10, <u>characterised in that</u> the additional phase modulation b(t) varies oscillatory in such manner that in the case of main groups comprising an even number of sub-groups, the number of complete oscillatory periods contained in a respective main group is equal to half the number of real sub-groups contained in this main group.

12. A component as claimed in one of Claims 1 to 11, <u>characterised in that</u> each sub-group has an even number of real finger edges.

13. A component as claimed in one of Claims 1 to 12, <u>characterised in that</u> all the fingers have constant length (constant overlapping).

## Revendications

1. Composant électronique travaillant avec des ondes acoustiques, sous la forme d'une structure interdigitée et/ou d'un dispositif "reflective array" et comportant des transducteurs d'entrée et de sortie et éventuellement au moins une structure formant réflecteur, la zone des doigts de l'une au moins de ces structures étant pondérée par un décalage des bords des doigts parallèlement à l'axe principal (Z) de la direction de propagation des ondes, caractérisé par le fait

que dans une telle zone pondérée - comparativement au cas où cette zone ne serait pas pondérée - il est prévu au moins deux bords réels successifs de doigts et éventuellement d'autres bords virtuels (62) de doigts, qui présentent en valeur et en direction le même type de décalage de leurs bords et forment un sous-groupe respectif (53, 54, 57, 59),

qu'il est prévu pour un nombre important de tels sous-groupes (53, 54, 57, 59), des décalages $\Delta Z$ oscillant les uns par rapport aux autres;

qu'il est prévu des groupes principaux (152) constitués par respectivement au moins deux sous-groupes réels (53, 54; 57, 58, 59),

qu'il est prévu n groupes principaux (152), n étant égal ou supérieur à T.B, qui est le produit d'une durée par une largeur de bande, T représentant la durée prédéterminée de la réponse impulsionnelle du filtre et B la largeur de bande prédéterminée de la fonction de transfert (1);

que la valeur respective du décalage des bords des doigts des différents sous-groupes respectifs de la suite des sous-groupes de cette zone pondérée correspond à une modulation oscillatoire supplémentaire de phase b(t) et que cette modulation de phase b(t) oscille de telle sorte qu'à l'intérieur d'un sous-groupe, le nombre des oscillations est un nombre entier qui n'est pas supérieur à la moitié du nombre des sous-groupes réels contenus dans ce groupe -principal, auquel cas on a

$$e^{jb(t)} \approx \tfrac{a(t)}{r(t)}$$

dans laquelle, $e^{jb(t)}$, qui est la moyenne de cette fonction exponentielle pour un groupe principal (152), est approximativement égale au rapport $\tfrac{a(t)}{r(t)}$, représentant la modulation prédéterminée d'amplitude de la réponse impulsionnelle du filtre et r(t) la fonction de l'enveloppe de la structure pondérée avec une modulation suplémentaire de phase, auquel cas r(t) est égale ou supérieure à a(t) pour toutes les valeurs de t; et

que la valeur du décalage $\Delta Z_i$ des bords des doigts du i-ème sous-groupe respectif est égale, au niveau de l'emplacement $Z_i$. du milieu de ce sous-groupe à

$$Z_i = \tfrac{\lambda_i}{2} \cdot b(t_i), \text{ avec } t_i = \tfrac{Z_i}{v},$$

Z représentant la coordonnée de la direction principale de la propagation des ondes à la vitesse v et $\lambda_i$ la longueur d'onde à l'emplacement du i-ème sous-groupe.

2. Composant suivant la revendication 1, caractérisé par le fait que la fonction de convolution g(t), que l'on obtient pour la réponse impulsionnelle globale prédéterminée du filtre s(t) = š(t) * g(t), la fonction š(t) étant la réponse impulsionnelle de la structure comportant les sous-groupes, et étant obtenue au moyen d'un dimensionnement correspondant de la largeur de bande d'une autre structure interdigitée (12) (transducteur d'entrée; transducteur de sortie) du composant, la largeur de bande de cette structure étant déterminée par son nombre de doigts.

3. Composant suivant la revendication 1, caractérisé par le fait que la fonction de convolution g(t), que l'on obtient pour la réponse impulsionnelle globale prédéterminée du filtre s(t) = š(t) * g(t), la fonction š(t) étant la réponse impulsionnelle de la structure comportant les sous-groupes, est réalisée par dimensionnement de l'ouverture de la structure formant réflecteur (33) conformément à une structure formant réflecteur à 90° (figure 4), l'ouverture étant déterminée essentiellement par la largeur de la structure, comptée perpendiculairement à la direction de propagation des ondes.

4. Composant suivant la revendication 1, 2 ou 3, caractérisé par le fait que le décalage $\Delta Z_i$ des bords (62) des doigts d'un sous-groupe respectif est prévu sur au moins une structure formant réflecteur (23, 33) du composant.

5. Composant suivant la revendication 4, caractérisé par le fait que la structure formant réflecteur est une structure formant réflecteur "in line" (figure 3).

6. Composant suivant la revendication 4, caractérisé par le fait que la structure formant réflecteur est une structure formant réflecteur à 90° (figure 4).

7. Composant suivant l'une des revendications 1 à 6, caractérisé par le fait que tous les sous-groupes (71), dont les bords des doigts sont décalés de $\Delta Z_i$ possèdent des doigts complets (figure 7).

8. Composant suivant l'une des revendications 1 à 7, caractérisé par le fait que les décalages $\Delta Z_i$, qui correspondent à la pondération des doigts, des bords des doigts des différents sous-groupes d'un ensemble de doigts, qui correspond à une structure digitée présentant une dispersion, sont superposés.

9. Composant suivant l'une des revendications 1 à 8, caractérisé par le fait que le décalage respectif $\Delta Z_i$ des bords des doigts dans les différents sous-groupes (57, 59) par rapport à la position du point médian du groupe principal associé est superposé aux intervalles identiques entre les positions centrales des groupes principaux successifs.

10. Composant suivant l'une des revendications 1 à 9, caractérisé par le fait que dans le cas de sous-groupes (53, 54) devant être décalés les uns par rapport aux autres, l'un des doigts voisins très rapprochés l'un de l'autre ou ces deux doigts sont supprimés en tant que doigts virtuels (56).

11. Composant suivant l'une des revendications 1 à 10, caractérisé par le fait que la modulation supplémentaire de phase b(t) oscille de telle sorte que dans le cas de groupes principaux comportant un nombre pair de ce groupe, le nombre des oscillations complètes contenues dans un groupe principal respectif est égal à la moitié du nombre des sous-groupes réels contenus dans ce groupe principal.

12. Composant suivant l'une des revendications 1 à 11, caractérisé par le fait que chaque sous-groupe possède un nombre pair de bords réels de doigts.

13. Composant suivant l'une des revendications 1 à 12, caractérisé par le fait que tous les doigts possèdent une longueur constante (chevauchement constant).

FIG1

FIG 6

FIG 7

FIG 8

FIG 2

FIG 3

FIG 4

FIG 5